# FASCICULE DE BREVET EUROPEEN

(11) **EP 3 284 316 B1**
(45) Date de publication et mention de la délivrance du brevet: **17.11.2021**
(21) Numéro de dépôt: 16719235.0
(22) Date de dépôt: 11.04.2016
(51) Int. Cl.: H05B 3/22, H05K 1/02, H05K 3/34

(54) **DISPOSITIF DE CHAUFFAGE ET REFROIDISSEMENT PAR CIRCUIT IMPRIMÉ POUR RÉGÉNÉRER DES COMPOSANTS ÉLECTRONIQUES SOUMIS À DES RADIATIONS**
VORRICHTUNG ZUR ERWÄRMUNG UND KÜHLUNG DURCH EINE LEITERPLATTE ZUR REGENERIERUNG VON ELEKTRONISCHEN, BESTRAHLUNG AUSGESETZTEN KOMPONENTEN
DEVICE FOR HEATING AND COOLING BY A PRINTED CIRCUIT FOR REGENERATING ELECTRONIC COMPONENTS SUBJECTED TO RADIATION

(30) Priorité: 13.04.2015 FR 1553178
(43) Date de publication de la demande: 21.02.2018
(73) Titulaire: Commissariat à l'Énergie Atomique et aux Énergies Alternatives, 75015 Paris (FR)
(72) Inventeur: ARMANI, Jean-Marc, 78180 Montigny Le Bretonneux (FR); MAZEAU, Jean-Lucien, 75005 Paris (FR)
(74) Mandataire: Marks & Clerk France
(86) Numéro de dépôt international: PCT/EP2016/057878
(87) Numéro de publication internationale: WO 2016/166043

(56) Documents cités:
- US-A1- 2009 051 446
- US-A1- 2010 112 826
- US-A1- 2012 201 008
- US-A1- 2014 027 435

## Description

L'invention se situe dans le domaine du durcissement aux rayonnements ionisants, et plus particulièrement à un dispositif permettant la régénération, sur un circuit imprimé, d'un composant électronique soumis à des radiations ionisantes par un recuit à température élevée.

Les composants électroniques CMOS (acronyme anglais pour Complementary Metal Oxide Semiconductor) sont sensibles aux radiations ionisantes gamma, et voient leurs caractéristiques électriques se dégrader après une exposition prolongée. Il est possible de régénérer les composants CMOS irradiés par l'application d'un recuit à température élevée. L'application de la régénération durant l'exploitation du composant peut permettre d'allonger significativement sa durée de vie en environnement radiatif.

Le refroidissement des composants qui ont été chauffés afin d'être régénérés peut permettre de retrouver une situation normale plus rapidement, et de diminuer ainsi la durée de non disponibilité du composant. Par ailleurs, le refroidissement peut également être utile dans le cas de circuits analogiques faible bruit petits signaux pour améliorer leur performances électriques.

Cependant, la diversité des types de composants du commerce peut rendre difficile l'application systématique de la chauffe ou du refroidissement directement sur le boitier. On peut citer en exemple certains capteurs photo ou vidéo, en boitiers à broches traversantes ou en boitiers BGA (acronyme anglais pour Ball Grid Array, ou matrice de billes), pour lesquels le dessus du boitier est inutilisable.

Le problème se pose également pour les composants de petites dimensions (inférieures à celles de la résistance de chauffe).

L'invention décrite apporte une solution pour ces situations en transférant de la chaleur ou du froid à un boitier de composant en utilisant des couches du circuit imprimé sur lequel il est monté.

Il est connu de l'homme du métier des solutions de chauffage de l'ensemble d'un circuit imprimé, permettant de réguler sa température pour permettre un fonctionnement dans des conditions environnementales hors des plages d'utilisation prévues en le chauffant en surface. Cependant, ces solutions ne permettent pas de porter l'un des composants du circuit à de très hautes températures.

L'une de ces solutions est par exemple décrite dans la demande de brevet US 6.262.392 B1. La Figure 1 décrit un cas où le circuit imprimé dispose d'une couche supérieure destinée à chauffer l'ensemble des composants du circuit. Dans cette solution, l'énergie thermique délivrée par des résistances est répartie sur l'ensemble de la couche supérieure. Cette solution pose le problème de la dissipation de l'énergie délivrée, qui peut être un problème pour atteindre les températures élevées nécessaires à la régénération par recuit d'un composant. Enfin, un tel dispositif chauffe l'ensemble des composants du circuit imprimé, ce qui peut dégrader les composants n'ayant pas vocation à être régénérés par le processus de recuit à haute température.

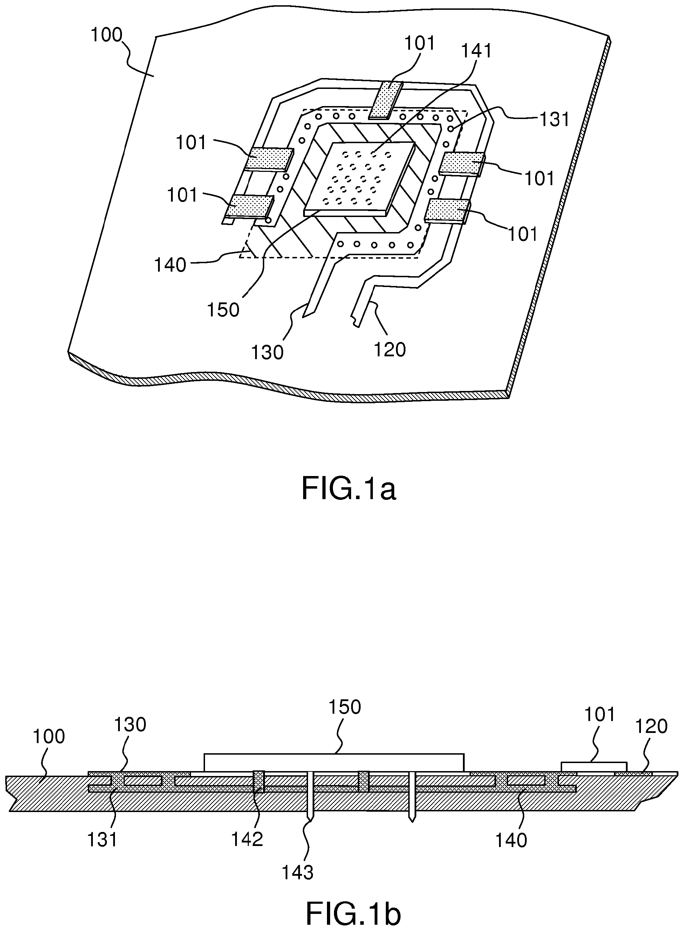

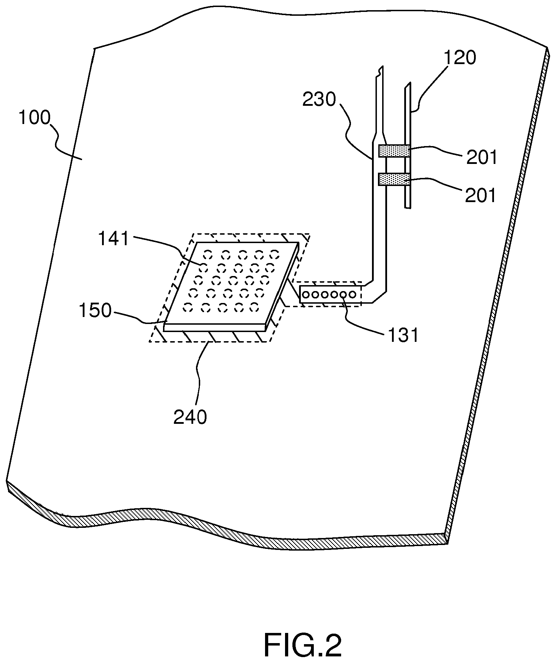

La Figure 2 de la même demande présente une solution dans laquelle la couche chauffante est située à l'intérieur du circuit imprimé. Cette solution pose, en plus des problèmes de la figure 1, le problème de la faible conductivité thermique entre la couche interne au circuit imprimé et les composants positionnés en surface.

Il est également connu de l'homme du métier des solutions de chauffage localisées sur un composant, comme dans le brevet US 8.445.818 B2. Ce brevet présente en Figure 2 une solution de chauffage d'un composant électronique sur un circuit imprimé, dans laquelle un composant destiné à produire de la chaleur est positionné sur le composant électronique à chauffer. Cependant, cette solution n'apporte pas de réponse aux cas où le dessus du boitier du composant électronique n'est pas accessible, ou aux cas où le boitier est de taille inférieure au composant chauffant.

Le même brevet présente en Figure 3 une solution de chauffage dans laquelle le circuit imprimé comprend une couche supérieure de chauffage, sur laquelle sont placés les composants électroniques. Cette solution n'est pas adaptée car la couche supérieure vient couvrir l'ensemble du circuit imprimé, et requiert l'utilisation de composants de chauffage positionnés à l'intérieur de la couche de chauffage.

L'invention propose donc de résoudre le problème du portage à haute température d'un composant sur un circuit imprimé, en particulier pour la réalisation du recuit d'un composant CMOS soumis à des radiations ionisantes et son refroidissement consécutif, en proposant un dispositif utilisant des résistances de chauffe ou des éléments produisant du froid montés en surface du circuit imprimé, et reliés à une surface de transfert thermique interne au circuit imprimé, disposée sous le composant, auquel elle est reliée par un ou plusieurs éléments métalliques, les éléments métalliques pouvant être les pattes du boitier ou des trous du circuit imprimé remplis par des liens métalliques, appelés vias.

La taille de la surface de transfert thermique est adaptée à la taille du composant, de manière à assurer une utilisation optimale de la chaleur produite par les résistances, et à atteindre ainsi les très hautes températures nécessaires à la réalisation d'un recuit, ces températures étant généralement supérieures à une centaine de degrés Celsius

L'invention s'applique également à des composants actifs destinés à produire du froid, permettant ainsi un retour accéléré à une température de fonctionnement nominale.

La demande de brevet US 2009/0051446 A1 traite du conditionnement thermique d'un composant électronique à une température proche de la température ambiante.

Ainsi, l'invention propose un dispositif de conditionnement thermique pour le recuit à température élevée d'un composant électronique de type semi-conducteur à oxyde de métal complémentaire, CMOS, monté dans un boitier positionné sur un circuit imprimé multicouches. Le dispositif comprenant:
- au moins un composant actif disposé sur ledit circuit imprimé, et adapté pour produire ou absorber une énergie thermique,
- au moins une surface de transfert thermique interne audit circuit imprimé localisée sous ledit boitier,
- au moins un dispositif de transfert de l'énergie entre le ou les dits composants actifs (101) et ladite surface de transfert thermique (140), le dispositif de transfert de l'énergie thermique comprenant une piste collectrice (130) reliée thermiquement au(x) dit(s) composants actifs (101), et en contact (332) avec le boitier (150) du composant électronique,
- au moins un élément métallique reliant ladite surface de transfert thermique audit boitier situé sur le circuit imprimé multicouches.

Dans un autre mode de réalisation du dispositif selon l'invention, la surface de transfert thermique est reliée à la piste collectrice, dont elle est isolée électriquement par des diodes de puissance.

Dans un autre mode de réalisation du dispositif selon l'invention lorsqu'il comprend une piste collectrice, le dispositif de transfert de l'énergie thermique comprend au moins un élément métallique reliant la piste collectrice à la surface de transfert thermique interne au circuit imprimée.

Dans un autre mode de réalisation, lorsque le ou les composants actifs destinés à produire de l'énergie thermique sont des composants à pattes traversantes, le transfert de l'énergie thermique produite est fait par au moins une des pattes du ou des composants actifs.

Avantageusement, dans l'ensemble des modes de réalisation du dispositif selon l'invention, la surface transfert thermique interne au circuit imprimé multicouches est positionnée dans la couche interne du circuit imprimé la plus proche du composant électronique.

Dans un autre mode de réalisation du dispositif selon l'invention, le dispositif de transfert de l'énergie thermique comprend une pluralité de surfaces conductrices internes au circuit imprimé, positionnées de part et d'autre d'une partie de ladite surface de transfert thermique sans contact avec celle-ci, lesdites surfaces conductrices (541, 542) étant reliées audit ou auxdits composants actifs (101) par au moins un élément métallique.

Avantageusement, le ou les composants actifs sont choisis parmi des résistances de chauffe et des éléments thermoélectriques.

Dans un mode de réalisation du dispositif selon l'invention, la surface de transfert thermique est reliée à un potentiel électrique du circuit imprimé.

Dans un autre mode de réalisation du dispositif selon l'invention, il comprend en outre un module de régulation de la température du composant électronique, configuré pour contrôler les éléments actifs.

L'invention adresse également un circuit imprimé multicouches comprenant un dispositif tel que décrit précédemment.

Enfin, l'invention adresse un procédé de conditionnement thermique pour le recuit à température élevée d'un composant électronique de type semi-conducteur à oxyde de métal complémentaire, CMOS, positionné dans un boitier situé sur un circuit imprimé multicouches, ledit circuit imprimé comprenant un dispositif tel que décrit précédemment. Le procédé est caractérisé en ce qu'il comprend une étape d'activation temporaire d'au moins un composant actif destiné à produire de la chaleur.

Le procédé peut également comprendre une étape postérieure d'activation temporaire d'au moins un composant actif destiné à produire du froid.

L'invention sera mieux comprise et d'autres caractéristiques et avantages apparaîtront à la lecture de la description qui suit, donnée à titre non limitatif, et grâce aux figures annexées parmi lesquelles :
- les figures 1a et 1b présentent une vue de dessus et une vue de coupe du dispositif selon un mode de réalisation de l'invention,
- la figure 2 présente une vue de dessus du dispositif selon un deuxième mode de réalisation de l'invention, dans lequel les éléments actifs sont éloignés de l'emplacement du composant électronique,
- les figures 3a et 3b représentent une vue de dessus et une vue de coupe du dispositif selon un troisième mode de réalisation de l'invention, dans lequel la piste collectrice est reliée au composant électronique,
- la figure 4 présente un schéma électrique permettant d'isoler électriquement la surface de transfert thermique de la piste collectrice,
- la figure 5 présente un autre mode de réalisation permettant d'isoler électriquement la surface de transfert thermique de la piste collectrice.

Les figures 1a et 1b présentent une vue de dessus et une vue de coupe du dispositif selon un premier mode de réalisation de l'invention.

Dans ce mode de réalisation, des éléments actifs 101 sont positionnés en surface d'un circuit imprimé 100. Ces éléments actifs sont reliés électriquement et thermiquement d'une part à une première piste 120, ayant un premier potentiel électrique, et d'autre part à une deuxième piste 130, nommé piste collectrice, ayant un deuxième potentiel électrique. Le premier potentiel électrique peut par exemple être une tension d'alimentation, et le deuxième potentiel électrique une masse. Toutes les configurations de potentiels sont possibles dès lors que les potentiels sont adaptés aux composants actifs et sont compatibles avec le composant à régénérer.

Les composants actifs sont adaptés pour produire ou absorber de l'énergie thermique. Ils peuvent par exemple être des résistances de chauffe, afin de produire de la chaleur, ou des éléments thermoélectriques Peltier, afin de produire du froid. Ces composants peuvent indifféremment être des composants à pattes traversantes, ou des composants CMS (acronyme de Composant Monté en Surface).

La suite du document parlera de production d'énergie thermique, donc de chaleur, mais s'applique de manière identique à l'absorption d'énergie thermique, donc la production de froid.

Le circuit imprimé multicouches comprend une surface de transfert thermique 140 interne au substrat du circuit imprimé. Cette surface de transfert thermique 140 couvre une zone située sous l'emplacement du boitier du composant électronique visé par le procédé de recuit. Sa forme est adaptée afin de couvrir une zone correspondant à l'emplacement du boitier du composant électronique et d'une partie de la piste collectrice, tout en étant la plus réduite possible. Pour une meilleure efficacité, il doit y avoir autour de cette surface une zone importante sans conducteurs métalliques, afin de conserver le plus localement possible la chaleur.

Cette surface de transfert thermique 140 est reliée aux éléments actifs 101 par un dispositif de transfert de l'énergie thermique. Dans la figure 1, ce dispositif de transfert se présente sous la forme de la piste collectrice 130, associée à des éléments métalliques 131 la reliant à la surface de transfert thermique 140. Dans d'autres modes de réalisation décrits par la suite, ce dispositif peut être matérialisé par les pattes des composants actifs, un entrelacement de couches internes au substrat, des combinaisons entre ces différents modes de réalisation, ou toute autre mise en œuvre permettant d'acheminer une énergie thermique entre les composants actifs 101 et la surface de transfert thermique 140, par conduction et/ou par rayonnement.

La surface de transfert thermique 140 est également reliée au boitier du composant électronique 150 vers lequel l'énergie thermique doit être transférée par des éléments métalliques 141.

Ainsi, les composants actifs 101 produisent une énergie thermique, qui est transmise à la piste collectrice 130 à laquelle ils sont reliés. La piste collectrice 130 transmet cette énergie à la surface de transfert thermique 140 interne au circuit imprimé par conduction à travers des éléments métalliques 131. Typiquement, ces éléments métalliques sont des vias réalisés dans le circuit imprimé de manière à relier la piste collectrice 130 à la surface de transfert thermique 140.

L'énergie thermique produite se propage ensuite dans la surface de transfert thermique 140, pour être transmise au composant électronique 150 par :
- rayonnement de la surface de transfert thermique 140 située sous le composant, ou absorption du rayonnement du composant électronique dans le cas de la production de froid, et
- conduction à travers les éléments métalliques 141.

Avantageusement, lorsque le boitier 150 du composant électronique est un boitier à pattes traversantes, les pattes 143 ayant le même potentiel électrique que la surface de transfert thermique 140, interne au substrat du circuit imprimé, peuvent être reliées à la surface de transfert thermique. C'est le cas sur la Figure 1b en coupe, où les éléments métalliques 141 reliant la surface de transfert thermique au boitier du composant électronique sont des vias 142 et des pattes 143 du boitier du composant électronique.

Ainsi, dans une variante d'un mode de réalisation de l'invention, la piste collectrice 130 et la surface de transfert thermique 140 sont reliées à la masse du circuit imprimé, les pattes traversantes de masse du composant électroniques étant alors reliées à la surface de transfert thermique.

De la même manière, lorsque les composants actifs sont des composants à pattes traversantes, ils peuvent être reliés directement à la surface de transfert thermique 140, la piste collectrice 130 n'étant alors plus indispensable au fonctionnement du dispositif.

Le dispositif de l'invention permet d'utiliser des éléments actifs 101 de taille limitée pour le conditionnement thermique d'un composant électronique par chauffe ou refroidissement. Ces composants n'étant pas en contact direct avec le boitier 150 du composant électronique, leur taille relative n'influe pas sur la faisabilité de la solution.

Ces éléments actifs sont montés sur le substrat du circuit imprimé par des techniques classiques de fabrication, bien que spécifiques au domaine de la haute température. La chaleur produite est concentrée sur une surface très limitée du circuit imprimé, évitant ainsi une trop forte déperdition. Cette chaleur est transmise au composant à chauffer, par rayonnement et conduction, en utilisant les couches internes du PCB et des liaisons électriques par des vias ou les pattes des composants.

Le positionnement des composants actifs d'un même côté du circuit imprimé peut permettre d'améliorer le transfert thermique vers le composant électronique en bénéficiant également d'une conduction directe de la chaleur sur les broches en périphérie de ce composant reliées directement au même potentiel électrique que celui de la surface de transfert thermique.

L'invention ne se limite pas au recuit d'un unique composant, mais peut être adaptée pour le recuit de plusieurs composants électroniques. Pour ceci, la surface de transfert thermique devra être disposée sous l'ensemble de ces composants. Dans un autre mode de réalisation, le circuit imprimé pourra comporter plusieurs surfaces de transfert thermique, chacune d'entre elles étant reliée à une même piste collectrice.

Afin que l'énergie transmise par rayonnement depuis la surface de transfert thermique vers le composant électronique soit la plus importante possible, la couche interne du circuit imprimée utilisée pour la surface de transfert thermique 140 est préférablement la couche la plus proche du composant. Idéalement, le substrat utilisé pour la réalisation du circuit imprimé atténue peu les rayonnements infrarouges.

Les largeurs des pistes 120 et 130 sont adaptées de manière à transmettre au mieux l'énergie thermique dans les zones d'intérêt. Ainsi, la piste 120, qui n'a pas vocation à transmettre l'énergie thermique, peut être la plus fine possible, de manière à minimiser la conduction thermique vers les autres éléments du circuit imprimé. Une largeur de piste inférieure à 1mm, comme par exemple 0.6 à 0.8 mm, est un bon compromis entre la chute de tension ohmique et la conduction thermique.

De même, la piste collectrice 130 est large dans la zone de collecte de l'énergie et d'échange vers la surface de transfert thermique 140, de manière à favoriser la conduction thermique, et plus fine dans la zone reliant électriquement cette piste à un potentiel thermique, afin de minimiser la conduction thermique dans cette zone.

La densité des éléments métalliques 131 et 141 reliant respectivement la piste collectrice 130 à la surface de transfert thermique 140, et la surface de transfert thermique 140 au composant électronique 150, impacte également la qualité des échanges thermiques, une forte densité d'éléments métalliques favorisant la conduction thermique.

L'invention permet donc d'acheminer de la chaleur ou du froid à un composant électronique, sans considération sur le format de son boitier, en utilisant des composants actifs standards et un procédé standard de réalisation du circuit imprimé. En effet, l'utilisation d'une surface thermique interne, reliée directement avec le boitier par des vias ou par une sélection de pattes du boitier, est compatible de circuits intégrés en boitiers à billes ou à broches, ce que ne permettrait pas l'utilisation d'une surface thermique positionnée en surface du circuit imprimé, qui serait moins efficace thermiquement, et générerait des risques de courts-circuits. Dans le cadre de l'invention, les vias ou les pattes dont le potentiel électrique est égal à celui de la surface de transfert apportent la chaleur/le froid au circuit intégré par conduction, tandis que la surface de transfert thermique située sous l'ensemble du boitier du composant électronique apporte un surcroit de chaleur par rayonnement.

L'efficacité de la chauffe ou du refroidissement est favorisée par l'utilisation d'une surface d'échanges limitée, ce qui permet d'utiliser des composants actifs de taille réduite. Cette solution est robuste, de par la redondance possible des éléments actifs autour du composant électronique, et de par l'utilisation de composants montés en surface, pouvant être facilement remplacés lorsqu'ils sont détériorés.

Les températures visées par le recuit étant très élevées (généralement supérieures à une centaine de degrés Celsius), le dispositif peut être associé à un équipement de génération de puissance permettant d'alimenter les éléments de chauffe du circuit imprimé.

Le dispositif peut également être associé à une sonde de température collée sur le composant, ou sur une zone proche, et à un système de régulation de la température, positionné sur le circuit imprimé, ou en dehors, en fonction des exigences dues à l'exposition aux radiations. Le système de régulation est configuré pour activer ou désactiver les éléments actifs 101 lors du recuit du composant électronique.

Idéalement, les composants actifs sont positionnés à proximité du composant électronique à chauffer, afin de réduire la taille de la surface de transfert thermique et la longueur de la piste collectrice. Cependant, il est possible de déporter la production de chaleur ou de froid dans des zones dédiées du circuit imprimé, la forme de la piste collectrice et de la surface de transfert thermique étant adaptées pour favoriser les échanges thermiques. C'est le cas représenté sur la Figure 2, où les composants actifs 201 sont déportés, la surface de transfert thermique 240 étant alors adaptée pour couvrir l'emplacement du boitier 150 du composant électronique et une partie de la piste collectrice 230.

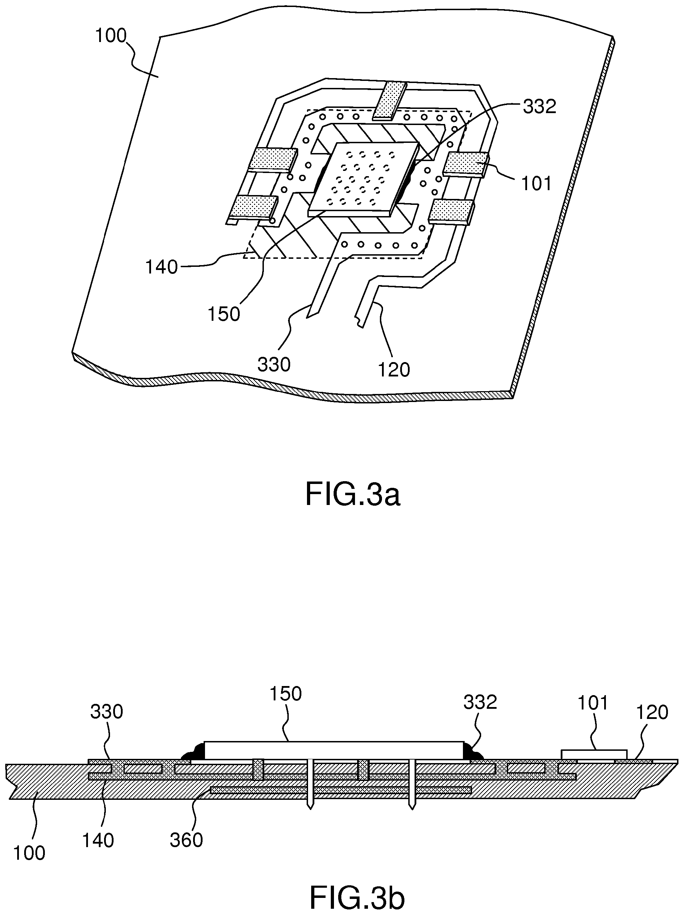

La Figure 3 illustre un troisième mode de réalisation, dans lequel la piste collectrice 330 se différencie de la piste collectrice 130 de la Figure 1 en ce qu'elle est en outre adaptée pour être en contact thermique avec le boitier du composant électronique 150. Les échanges thermiques entre la piste collectrice et le composant peuvent être favorisés par l'utilisation de pâte thermique 332.

Avantageusement, afin de favoriser le rayonnement de la surface de transfert thermique sur le composant électronique, un plan réflecteur métallique 360 est positionné sous cette surface de transfert thermique. L'énergie thermique rayonnée par la surface de transfert thermique 140 en direction du plan réflecteur 360 est alors renvoyée vers la surface de transfert thermique et le composant électronique 150, diminuant ainsi les déperditions d'énergie.

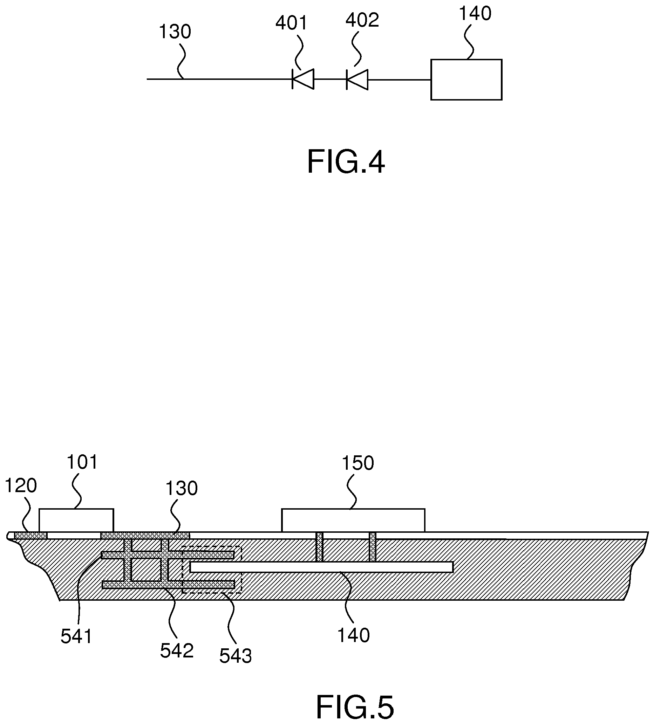

La Figure 4 présente un schéma électrique permettant d'isoler électriquement la surface de transfert thermique de la piste collectrice.

Dans le cas où le composant électronique est sensible aux variations de courant, il peut être avantageux d'isoler électriquement la surface de transfert thermique de la piste collectrice. Pour ceci, des diodes silicium de puissance 401 et 402 sont disposées tête bèche entre la piste collectrice 130 et la surface de transfert thermique 140.

La figure 5 présente un autre mode de réalisation permettant d'isoler électriquement la surface de transfert thermique. Dans ce mode de réalisation, le dispositif de transfert de l'énergie thermique entre les composants actifs 101 et la surface de transfert thermique 140 est matérialisé par un entrelacement de couches internes au substrat du circuit imprimé, permettant ainsi de transférer par rayonnement l'énergie thermique à la surface de transfert thermique sans réaliser de contact électrique entre cette surface et la piste collectrice. Pour ceci, la surface de transfert thermique 140, interne au substrat du circuit imprimé, est positionnée entre au moins deux surfaces conductrices 541 et 542, ces surfaces conductrices étant situées dans des couches internes au substrat du circuit imprimé, le plus proche possible de la surface de transfert thermique, mais sans être contacts avec celle-ci. Ces surfaces conductrices sont reliées à la piste collectrice 130 ou directement aux composants actifs 101, par des éléments métalliques comme des vias ou les pattes des composants. Une zone 543, commune à la surface de transfert thermique 140 et aux surfaces conductrices 541 et 542 situées de part et d'autre de cette surface de transfert thermique, permet le transfert par rayonnement d'énergie thermique sans mettre en contact électriquement la surface de transfert thermique 140 avec les éléments de chauffe 101 du dispositif. Selon le même principe, il est possible d'utiliser plus de deux surfaces conductrices, pour augmenter l'énergie rayonnée.

L'invention adresse également un procédé utilisant le dispositif décrit précédemment pour transférer de la chaleur à un composant électronique dans le but d'opérer un recuit, le procédé consistant à alimenter des éléments actifs destinés à produire de la chaleur, pendant une durée limitée, ou jusqu'à une température cible.

Le procédé peut également être suivi par une étape d'alimentation d'éléments actifs destinés à produire du froid, pendant une durée limitée, ou jusqu'à ce que la température du composant soit ramenée dans une plage prédéfinie.

## Revendications

1. Dispositif de conditionnement thermique pour le recuit à température élevée d'un composant électronique de type semi-conducteur à oxyde de métal complémentaire, CMOS, monté dans un boîtier (150) positionné sur un circuit imprimé multicouches (100), ledit dispositif comprenant
• au moins un composant actif (101) disposé sur ledit circuit imprimé, et adapté pour produire ou absorber une énergie thermique,
• au moins une surface de transfert thermique (140) interne audit circuit imprimé localisée sous ledit boitier,
• un dispositif (131, 541, 542) de transfert de l'énergie thermique entre le ou les dits composants actifs (101) et ladite surface de transfert thermique (140), le dispositif de transfert de l'énergie thermique comprenant une piste collectrice (130) reliée thermiquement au(x) dit(s) composants actifs (101), et en contact (332) avec le boitier (150) du composant électronique,
• au moins un élément métallique (141) reliant ladite surface de transfert thermique (140) audit boitier (150) situé sur le circuit imprimé multicouches.

2. Dispositif de conditionnement thermique pour le recuit à température élevée d'un composant électronique selon la revendication 1, dans lequel ladite surface de transfert thermique (140) est reliée à ladite piste collectrice (130) dont elle est isolée électriquement par des diodes de puissance (401, 402).

3. Dispositif de conditionnement thermique pour le recuit à température élevée d'un composant électronique selon l'une des revendications précédentes, dans lequel ledit dispositif de transfert de l'énergie thermique comprend au moins un élément métallique (131) reliant ladite piste collectrice (130) à ladite surface de transfert thermique (140) interne au circuit imprimée.

4. Dispositif de conditionnement thermique pour le recuit à température élevée d'un composant électronique selon l'une des revendications précédentes, dans lequel le ou les composants actifs (101) sont des composants à pattes traversantes, et dans lequel ledit dispositif de transfert de l'énergie thermique comprend au moins une des pattes du ou des composants actifs (101).

5. Dispositif de conditionnement thermique d'un composant électronique selon l'une des revendications précédentes, dans lequel ladite surface de transfert thermique (140) interne au circuit imprimé multicouches est positionnée dans la couche interne la plus proche du composant électronique.

6. Dispositif de conditionnement thermique pour le recuit à température élevée d'un composant électronique selon l'une des revendications 1 à 3, dans lequel ledit dispositif de transfert de l'énergie thermique comprend une pluralité de surfaces conductrices (541, 542) internes audit circuit imprimé, positionnées de part et d'autre d'une partie (543) de ladite surface de transfert thermique (140) sans contact avec celle-ci, lesdites surfaces conductrices (541, 542) étant reliées audit ou auxdits composants actifs (101) par au moins un élément métallique.

7. Dispositif de conditionnement thermique pour le recuit à température élevée d'un composant électronique selon l'une des revendications précédentes, dans lequel le ou les composants actifs (101) sont choisis parmi des résistances de chauffe et des éléments thermoélectriques.

8. Dispositif de conditionnement thermique pour le recuit à température élevée d'un composant électronique selon l'une des revendications précédentes, dans lequel ladite surface de transfert thermique (140) est reliée à un potentiel électrique du circuit imprimé.

9. Dispositif de conditionnement thermique pour le recuit à température élevée d'un composant électronique selon l'une des revendications précédentes, comprenant en outre un module de régulation de la température du composant électronique configuré pour contrôler les éléments actifs (101).

10. Dispositif de conditionnement thermique pour le recuit à température élevée d'un composant électronique selon l'une des revendications précédentes, dans lequel le boitier du composant électronique est un boîtier à billes ou un boitier à broches.

11. Circuit imprimé multicouches comprenant un dispositif de conditionnement thermique pour le recuit à température élevée d'un composant électronique selon l'une des revendications 1 à 10.

12. Procédé de conditionnement thermique pour le recuit à température élevée d'un composant électronique de type semi-conducteur à oxyde de métal complémentaire, CMOS, positionné dans un boitier (150) situé sur un circuit imprimé multicouches (100), ledit circuit imprimé comprenant un dispositif selon l'une des revendications 1 à 10, **caractérisé en ce qu'**il comprend une étape d'activation temporaire d'au moins un composant actif destiné à produire de la chaleur.

13. Procédé de conditionnement thermique pour le recuit à température élevée d'un composant électronique selon la revendication 12, comprenant en outre une étape postérieure à l'étape d'activation temporaire d'au moins un composant actif destiné à produire de la chaleur, d'activation temporaire d'au moins un composant actif destiné à produire du froid.

## Patentansprüche

1. Vorrichtung zur thermischen Konditionierung zum Hochtemperaturglühen eines elektronischen Bauteils vom Typ Halbleiter mit komplementärem Metalloxid, CMOS, das in einem Gehäuse (150) montiert ist, das auf einer mehrschichtigen Leiterplatte (100) positioniert ist, wobei die Vorrichtung Folgendes umfasst:
• mindestens ein aktives Bauteil (101), das auf der Leiterplatte angeordnet und geeignet ist, thermische Energie zu erzeugen oder zu absorbieren,
• mindestens eine Wärmeübertragungsfläche (140) im Innern der Leiterplatte, die unterhalb des Gehäuses lokalisiert ist,
• eine Vorrichtung (131, 541, 542) zur Übertragung thermischer Energie zwischen dem aktiven Bauteil oder den aktiven Bauteilen (101) und der Wärmeübertragungsfläche (140), wobei die Vorrichtung zur Übertragung der thermischen Energie eine Sammelspur (130) umfasst, die thermisch mit dem aktiven Bauteil oder den aktiven Bauteilen (101) verbunden ist und in Kontakt (332) mit dem Gehäuse (150) des elektrischen Bauteils steht,
• mindestens ein Metallelement (141), das die Wärmeübertragungsfläche (140) mit dem Gehäuse (150) verbindet, das auf der mehrschichtigen Leiterplatte befindlich ist.

2. Vorrichtung zur thermischen Konditionierung zum Hochtemperaturglühen eines elektronischen Bauteils nach Anspruch 1, wobei die Wärmeübertragungsfläche (140) mit der Sammelspur (130) verbunden ist, von der sie elektrisch durch Leistungsdioden (401, 402) isoliert ist.

3. Vorrichtung zur thermischen Konditionierung zum Hochtemperaturglühen eines elektronischen Bauteils nach einem der vorhergehenden Ansprüche, wobei die Vorrichtung zur Übertragung der thermischen Energie mindestens ein Metallelement (131) umfasst, das die Sammelspur (130) mit der Wärmeübertragungsfläche (140) im Innern der Leiterplatte verbindet.

4. Vorrichtung zur thermischen Konditionierung zum Hochtemperaturglühen eines elektronischen Bauteils nach einem der vorhergehenden Ansprüche, wobei das aktive Bauteil oder die aktiven Bauteile (101) Bauteile mit Durchgangslaschen sind, und wobei die Vorrichtung zur Übertragung der thermischen Energie mindestens eine der Laschen des aktiven Bauteils oder der aktiven Bauteile (101) umfasst.

5. Vorrichtung zur thermischen Konditionierung für ein elektronisches Bauteil nach einem der vorhergehenden Ansprüche, wobei die Wärmeübertragungsfläche (140) im Innern der mehrschichtigen Leiterplatte in derjenigen inneren Schicht positioniert ist, die dem elektronischen Bauteil am nächsten ist.

6. Vorrichtung zur thermischen Konditionierung zum Hochtemperaturglühen eines elektronischen Bauteils nach einem der Ansprüche 1 bis 3, wobei die Vorrichtung zur Übertragung der thermischen Energie eine Vielzahl von leitfähigen Flächen (541, 542) im Innern der Leiterplatte umfasst, die beiderseits eines Teils (543) der Wärmeübertragungsfläche (140) positioniert sind, ohne Kontakt mit dieser Fläche, wobei die leitfähigen Flächen (541, 542) mit dem aktiven Bauteil oder den aktiven Bauteilen (101) durch mindestens ein Metallelement verbunden sind.

7. Vorrichtung zur thermischen Konditionierung zum Hochtemperaturglühen eines elektronischen Bauteils nach einem der vorhergehenden Ansprüche, wobei das aktive Bauteil oder die aktiven Bauteile (101) aus Heizwiderständen und thermoelektrischen Elementen gewählt sind.

8. Vorrichtung zur thermischen Konditionierung zum Hochtemperaturglühen eines elektronischen Bauteils nach einem der vorhergehenden Ansprüche, wobei die Wärmeübertragungsfläche (140) mit einem elektrischen Potenzial der Leiterplatte verbunden ist.

9. Vorrichtung zur thermischen Konditionierung zum Hochtemperaturglühen eines elektronischen Bauteils nach einem der vorhergehenden Ansprüche, ferner umfassend ein Temperaturregelungsmodul des elektronischen Bauteils, das zum Steuern der aktiven Bauteile (101) konfiguriert ist.

10. Vorrichtung zur thermischen Konditionierung zum Hochtemperaturglühen eines elektronischen Bauteils nach einem der vorhergehenden Ansprüche, wobei das Gehäuse des elektronischen Bauteils ein Kugelgehäuse oder ein Stiftgehäuse ist.

11. Mehrschichtige Leiterplatte, umfassend eine Vorrichtung zur thermischen Konditionierung zum Hochtemperaturglühen eines elektronischen Bauteils nach einem der Ansprüche 1 bis 10.

12. Verfahren zur thermischen Konditionierung zum Hochtemperaturglühen eines elektronischen Bauteils vom Typ Halbleiter mit komplementärem Metalloxid, CMOS, das in einem Gehäuse (150) positioniert ist, das auf einer mehrschichtigen Leiterplatte (100) befindlich ist, wobei die Leiterplatte eine Vorrichtung nach einem der Ansprüche 1 bis 10 umfasst, **dadurch gekennzeichnet, dass** es einen Schritt der zeitweiligen Aktivierung mindestens eines aktiven Bauteils umfasst, das zur Erzeugung von Wärme bestimmt ist.

13. Verfahren zur thermischen Konditionierung zum Hochtemperaturglühen eines elektronischen Bauteils nach Anspruch 12, ferner umfassend einen dem Schritt der zeitweiligen Aktivierung mindestens eines aktiven Bauteils, das zur Erzeugung von Wärme bestimmt ist, folgenden Schritt der zeitweiligen Aktivierung mindestens eines aktiven Bauteils, das zur Erzeugung von Kälte bestimmt ist.

## Claims

1. A thermal conditioning device for high temperature annealing of a complementary metal oxide semiconductor, CMOS, electronic component mounted in a housing (150) positioned on a multilayer printed circuit board (100), said device comprising:
• at least one active component (101) arranged on said printed circuit board, and suitable for producing or absorbing thermal energy,
• at least one heat transfer surface (140) internal to said printed circuit board, located under said housing,
• a device (131, 541, 542) for transferring the thermal energy between said active component or components (101) and said heat transfer surface (140), the device for transferring the thermal energy comprising a collector track (130) thermally linked to said active component(s) (101), and in contact (332) with the electronic component housing (150),
• at least one metallic element (141) linking said heat transfer surface (140) to said housing (150) situated on the multilayer printed circuit.

2. The thermal conditioning device for high temperature annealing of an electronic component according to claim 1, wherein said heat transfer surface (140) is linked to said collector track (130) from which it is electrically isolated by power diodes (401, 402).

3. The thermal conditioning device for high temperature annealing of an electronic component according to one of the preceding claims, wherein said device for transferring the thermal energy comprises at least one metallic element (131) linking said collector track (130) to said heat transfer surface (140) internal to the printed circuit board.

4. The thermal conditioning device for high temperature annealing of an electronic component according to one of the preceding claims, wherein the active component or components (101) are components with through-hole leads, and wherein said device for transferring the thermal energy comprises at least one of the leads of the active component or components (101).

5. The thermal conditioning device for an electronic component according to one of the preceding claims, wherein said heat transfer surface (140) internal to the multilayer printed circuit board is positioned in the internal layer closest to the electronic component.

6. The thermal conditioning device for high temperature annealing of an electronic component according to one of claims 1 to 3, wherein said device for transferring the thermal energy comprises a plurality of conductive surfaces (541, 542) internal to said printed circuit board, positioned on either side of a part (543) of said heat transfer surface (140) without contact therewith, said conductive surfaces (541, 542) being linked to said active component or components (101) by at least one metallic element.

7. The thermal conditioning device for high temperature annealing of an electronic component according to one of the preceding claims, wherein the active component or components (101) are chosen from among heating resistors and thermoelectric elements.

8. The thermal conditioning device for high temperature annealing of an electronic component according to one of the preceding claims, wherein said heat transfer surface (140) is linked to an electrical potential of the printed circuit board.

9. The thermal conditioning device for high temperature annealing of an electronic component according to one of the preceding claims, further comprising a module for regulating the temperature of the electronic component, configured to control the active elements (101).

10. The thermal conditioning device for high temperature annealing of an electronic component according to one of the preceding claims, wherein the housing of the electronic component is a ball grid array housing or a pin grid array housing.

11. A multilayer printed circuit board comprising a thermal conditioning device for high temperature annealing of an electronic component according to one of claims 1 to 10.

12. A thermal conditioning method for high temperature annealing of a complementary metal oxide semiconductor, CMOS, electronic component positioned in a housing (150) situated on a multilayer printed circuit board (100), said printed circuit board comprising a device according to one of claims 1 to 10, **characterised in that** it comprises a step of temporary activation of at least one active component intended to produce heat.

13. The thermal conditioning method for high temperature annealing of a an electronic component according to claim 12, further comprising a step subsequent to the step of temporary activation of at least one active component intended to produce heat, of temporary activation of at least one active component intended to produce cold.
